Europäisches Patentamt

European Patent Office

Office européen des brevets

(11) Numéro de publication : **0 616 227 A1**

(12) # DEMANDE DE BREVET EUROPEEN

(21) Numéro de dépôt : **94400546.1**

(22) Date de dépôt : **14.03.94**

(51) Int. Cl.⁵ : **G01R 33/24**

(30) Priorité : **16.03.93 FR 9303008**

(43) Date de publication de la demande :
**21.09.94 Bulletin 94/38**

(84) Etats contractants désignés :
**BE CH DE DK GB LI SE**

(71) Demandeur : **COMMISSARIAT A L'ENERGIE ATOMIQUE**
**31-33, rue de la Fédération**
**F-75015 Paris (FR)**

(72) Inventeur : **Duret, Denis**
**13, rue de Stalingrad**
**F-38100 Grenoble (FR)**

(74) Mandataire : **Signore, Robert**
**c/o BREVATOME**
**25, rue de Ponthieu**
**F-75008 Paris (FR)**

(54) **Magnomètre directionnel à résonance de type numérique.**

(57)   Le magnétomètre de l'invention comprend un organe logique (50) recevant un signal de détection de résonance, un processeur numérique (60) délivrant un nombre N, un convertisseur numérique-analogique transformant ce nombre en courant servant à établir une contre-réaction. La mesure du champ est donnée directement en numérique par le processeur.

Application en magnétométrie.

FIG. 7

## Domaine technique

La présente invention a pour objet un magnétomètre directionnel à résonance de type numérique. Elle trouve une application dans la mesure des champs magnétiques faibles, par exemple de quelques dizaines de microteslas.

L'invention trouve des applications en géophysique, en prospection minière, en détection spatiale, etc...

## Etat de la technique antérieure

Le magnétomètre de l'invention est du type directionnel à résonance. Ces appareils sont bien connus et décrits, par exemple, dans la demande de brevet français FR-A-2 663 751 déposée par le présent Demandeur (cette demande contenant elle-même des références bibliographiques sur le sujet), ou dans la demande européenne correspondante EP-A-463 919, ou encore dans l'article de D. DURET, M. MOUSSAVI et M. BERANGER intitulé "Use of High Performance Electron Spin Resonance Materials for the Design of Scalar and Vectorial Magnetometers", publié dans la revue IEEE Transactions on Magnetics, vol. 27, n° 6, nov. 1991, pp. 5405-5407.

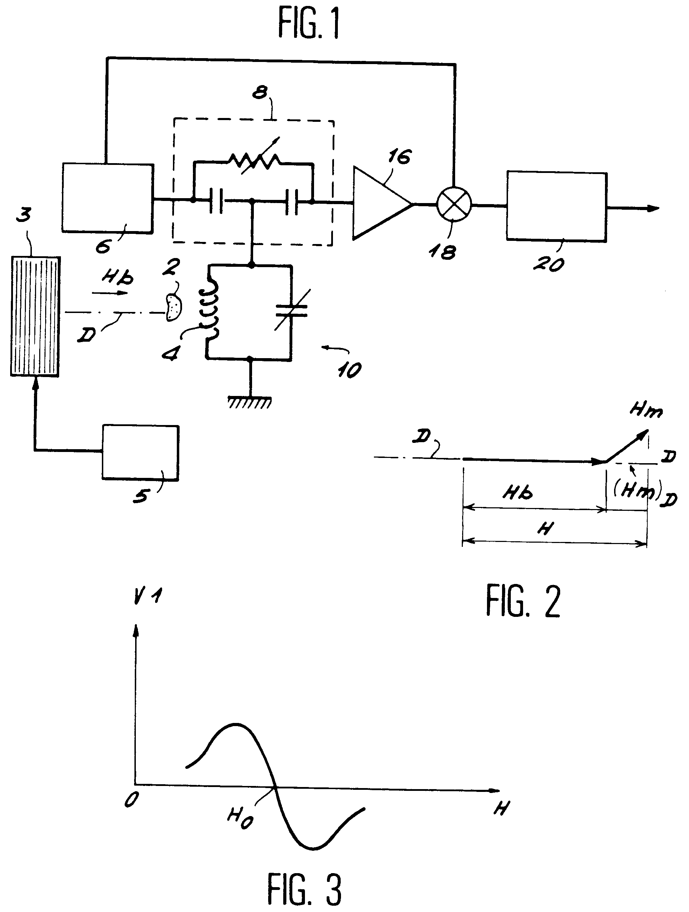

On peut rappeler brièvement la structure et le fonctionnement de ces appareils dans quelques une de leurs variantes et ceci en référence aux figures 1 à 6 annexées.

Sur la figure 1, tout d'abord, on voit un échantillon 2 contenant un matériau possédant des spins électroniques ou nucléaires ; un premier enroulement 3 créant un champ magnétique de polarisation noté Hb et dirigé selon une direction D ; un second enroulement 4 à proximité de l'échantillon 2 ; un générateur de courant 5 d'intensité réglable alimentant le premier enroulement 3 ; un générateur haute-fréquence 6 relié à un pont de mesure 8, lequel est relié à son tour à un circuit résonnant 10 contenant l'enroulement 4 ; un amplificateur à faible bruit 16 relié au pont de mesure 8 ; un mélangeur équilibré 18 recevant, d'une part, la tension délivrée par l'amplificateur 16, et, d'autre part, une tension de référence émanant du générateur haute-fréquence 6 ; et, enfin, un filtre passe-bas 20.

L'échantillon 2 est soumis au champ à mesurer, soit Hm, ainsi qu'au champ de polarisation Hb. Ces deux champs ne sont pas en général colinéaires. Le champ magnétique mesuré par un tel appareil est, en fait, la somme de Hb et de la composante de Hm projetée sur la direction D, composante notée $(Hm)_D$, compte tenu du fait que Hb est beaucoup plus grand que Hm Ces divers champs ou composantes sont représentés sur la figure 2. Le champ total dans la direction D est noté H.

Le fonctionnement de cet appareil est le suivant.

Le générateur 6, connecté au circuit 10 et à son enroulement 4, est apte à exciter la résonance des spins de l'échantillon 2. Sa fréquence est fixée avec une très grande précision ($10^{-9}$ à $10^{-6}$). La résonance des spins se produit lorsque la fréquence fo du signal d'excitation est égale à la fréquence de LARMOR, classiquement déterminée par la relation $(1/(2\pi))\gamma Ho$, où $\gamma$ est le rapport gyromagnétique propre à l'échantillon utilisé (dans le cas de l'électron $\gamma = 2\pi.28$ GHz/T) et Ho est la valeur à la résonance du champ magnétique total appliqué.

Le circuit 10 et son enroulement 4 sont, en même temps, aptes à détecter cette résonance, le circuit 8 ayant pour fonction de découpler l'excitation et la détection.

L'appareil représenté sur la figure 1 détecte le passage par la résonance lorsque, la fréquence fo étant fixée, le champ total H passe par la valeur Ho. La figure 3 montre ainsi les variations de la tension V1 délivrée par le filtre passe-bas 20 lorsque le champ H varie et passe par Ho. Cette courbe est du type dispersion, c'est-à-dire antisymétrique, avec une partie positive, une annulation (pour la valeur Ho correspondant à la résonance) et une partie négative. La connaissance de Ho permet de remonter à $(Hm)_D$ si l'on connaît Hb.

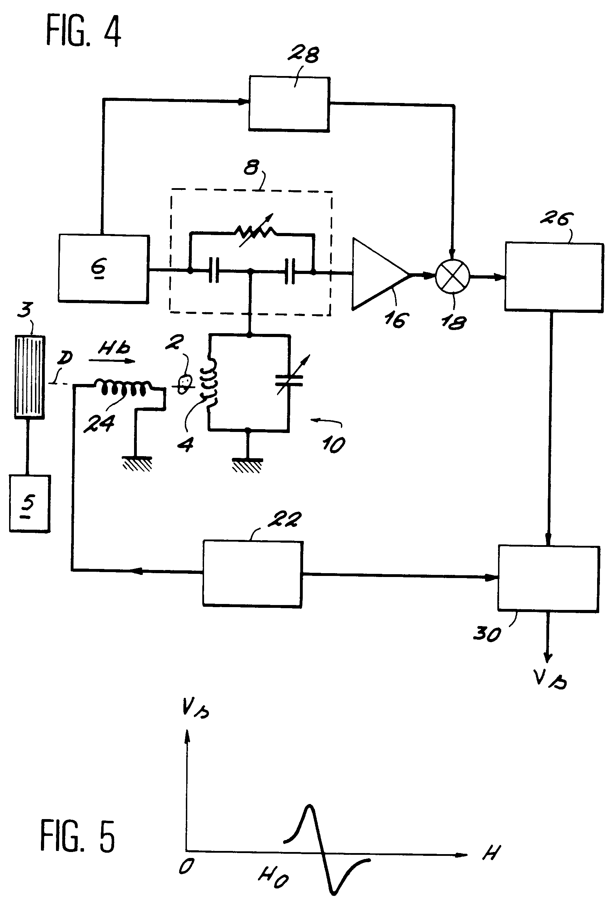

Le dispositif de la figure 4 est une variante dans laquelle on utilise en outre un oscillateur 22 et un enroulement 24 pour engendrer un champ magnétique ayant une fréquence-audio notée fm, ce champ, appelé "champ d'agitation", se superposant au champ de polarisation Hb.

Par ailleurs, dans la variante de la figure 4 et à la sortie du mélangeur équilibré 18, le filtre passe-bas 20 de la figure 1 est remplacé par un filtre passe-bande 26 centré autour de la fréquence fm. Un déphaseur 28 reçoit le signal de haute fréquence issu du générateur 6 et fournit au mélangeur équilibré 18 un signal de phase appropriée.

Un circuit 30 de détection synchrone à la fréquence fm reçoit sur l'une de ses entrées un signal de référence issu du générateur 22. Ce signal de référence possède une fréquence fm mais son amplitude et sa phase peuvent être rendues différentes de celles du signal fourni par l'oscillateur 22 à la bobine 24. Le circuit 30 possède une autre entrée reliée à la sortie du filtre 26 et il délivre finalement une tension Vs.

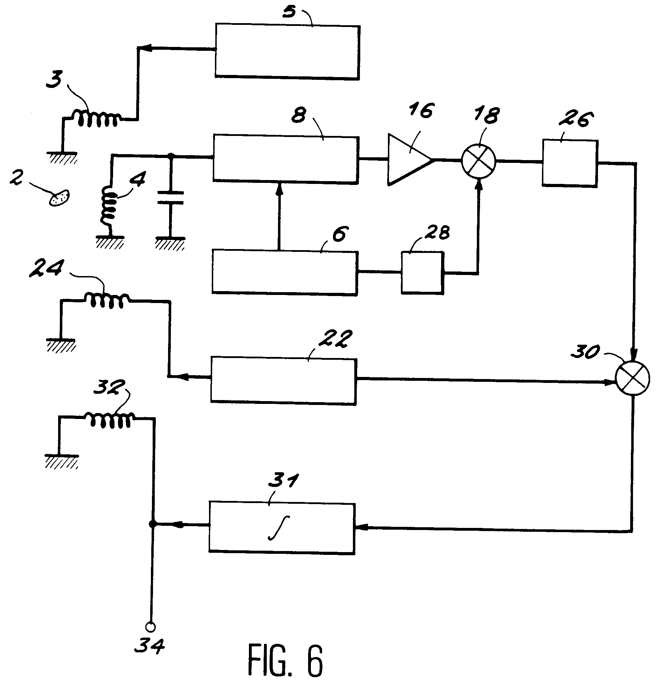

En montant à la sortie du moyen de détection synchrone 30 un moyen d'observation approprié (non représenté), on peut observer la courbe des variations de Vs en fonction du champ total H. Cette courbe est représentée sur la figure 5. Comme celle de la figure 3, il s'agit d'une courbe antisymétrique avec annulation pour la valeur Ho du champ correspondant à la résonance des spins.

Avec de tels appareils, une variation du champ à mesurer Hm, si elle est très inférieure à la largeur des raies représentées sur les figures 3 et 5, se traduit par un écart par rapport à la valeur de résonance et par l'apparition d'une tension (V1 ou Vs) non nulle en sortie du magnétomètre. Cette tension varie sensiblement linéairement en fonction de l'écart à Ho.

La linéarité peut être améliorée par une contre-réaction de champ, obtenue en se servant de la tension V1 (figure 3) ou de la tension Vs (figure 5) comme signal d'erreur, en intégrant cette tension et en injectant, dans une bobine de contre-réaction, un courant proportionnel à la tension intégrée. L'axe de cette bobine de contre-réaction doit encore être parallèle à la direction D du champ de polarisation.

C'est ce qu'on trouve dans le schéma de la figure 6 où apparaissent, en plus des moyens déjà représentés sur la figure 4, un intégrateur 31 et un enroulement 32 de contre-réaction. Dans un tel appareil, le champ total est toujours maintenu à la valeur correspondant à la résonance et le signal d'erreur intégré constitue en fait le signal de mesure. Ce dernier apparaît sur la sortie 34 de l'appareil.

En d'autres termes, quel que soit le champ appliqué de l'extérieur à l'échantillon, cet échantillon voit, le long de la direction D, le même champ, à savoir celui qui assure la résonance des spins. Comme le champ correspondant à la résonance est beaucoup plus grand (plus de dix fois) que le champ d'origine extérieure à mesurer, le module de la somme vectorielle (cf. fig. 2) est sensiblement égal à la somme du champ crée par le courant de polarisation et dirigé selon la direction D et de la projection sur cette direction du champ extérieur à mesurer.

Autrement dit, les moyens 31 et 32 réalisent un asservissement de l'appareil à la résonance, quel que soit le champ appliqué de l'extérieur.

On peut noter encore que, dans le mode de réalisation illustré sur la figure 6, les trois enroulements, respectivement de polarisation 3, d'agitation 24 et de contre-réaction 32, sont supposés distincts ; mais comme ils ont tous le même axe, ils peuvent très bien être confondus en un seul et même enroulement.

Quant à l'intégrateur 31, il peut soit délivrer directement le courant de contre-réaction, soit délivrer une tension, auquel cas il faut lui associer un convertisseur tension-courant, sous la forme par exemple d'une résistance.

On retiendra de cet exposé de l'état de la technique, que les magnétomètres directionnels à résonance connus comprennent en général un échantillon à spins soumis au champ à mesurer, des moyens pour appliquer à cet échantillon un champ magnétique de polarisation, des moyens pour appliquer à l'échantillon un champ radiofréquence et exciter la résonance des spins, des moyens pour détecter cette résonance, des moyens pour engendrer un signal électrique antisymétrique qui s'annule lorsque le champ total appliqué à l'échantillon prend la valeur Ho correspondant à la résonance des spins et qui est positif ou négatif selon que le champ total appliqué est plus grand ou plus petit que cette valeur particulière (Ho). En l'absence de champ à mesurer, l'appareil est réglé pour être à la résonance. En présence d'un champ à mesurer, le champ de contre-réaction rétablit la résonance et la valeur du signal d'erreur intégré (ou du courant de contre-réaction) constitue la mesure du champ magnétique.

Bien que donnant satisfaction à certains égards, ces magnétomètres présentent néanmoins des inconvénients. En particulier, ils sont de caractère analogique, de sorte que si l'on veut disposer d'une mesure en numérique, il faut leur associer un convertisseur analogique-numérique. Or, dans l'état actuel de ces composants, il ne semble pas que la précision de ces convertisseurs soit adaptée à la très grande précision requise pour certains magnétomètres. En effet, lorsqu'il s'agit de mesurer, par exemple, le champ magnétique terrestre, dont la valeur est d'environ 50 microteslas, l'erreur tolérée est de 10 picoteslas. Ceci impose donc une résolution de 0,2 pour mille. Une telle précision correspond à un convertisseur analogique-numérique de 22 bits, lequel n'existe pas dans l'état actuel de la technique.

## Exposé de l'invention

La présente invention a justement pour but de remédier à cet inconvénient. A cette fin, elle propose un magnétomètre qui comprend, intrinsèquement, des moyens numériques tels que le signal délivré par l'appareil soit non seulement déjà en numérique, mais corresponde à une précision adaptée aux grandes performances de l'appareil.

Ce résultat est obtenu, selon l'invention, par l'utilisation de moyens au moins en partie numérique pour former le signal d'erreur et établir la contre-réaction qui ramènera le magnétomètre à la résonance.

En l'absence de champ à mesurer, et comme dans l'art antérieur décrit plus haut, pour obtenir la résonance des spins à la fréquence fo du générateur d'excitation, on applique à l'échantillon un champ Ho défini par $2\pi fo/\gamma$. Ceci peut être obtenu par tout moyen approprié. Lorsqu'un champ à mesurer est appliqué à l'échantillon, la résonance disparaît. Pour la retrouver, il faut établir un courant de contre-réaction à partir du signal d'erreur obtenu. Selon l'invention, cette fonction est remplie par des moyens logiques et numériques. Un signal d'erreur numérique est engendré sous forme d'un nombre à plusieurs digits. A partir de ce nombre, un courant de contre-réaction est formé qui, appliqué à l'un des enroulements prévus classiquement, permet de rétablir la résonance. Le passage par la résonance est détecté par un organe logique qui bloque le nombre à sa valeur correspondante, celle-ci étant alors la traduction du champ à mesurer. On obtient donc ainsi directement la valeur du champ magnétique en numérique.

Selon l'invention, le champ de polarisation Ho est créé soit par des moyens de polarisation (dans ce cas il se superpose au champ de contre-réaction lorsqu'il existe), soit par des moyens de contre-réaction qui engendrent alors un champ correspondant à la somme de Ho et du champ de contre-réaction.

## Brève description des dessins

- la figure 1 montre une variante de magnétomètre directionnel à résonance selon l'art antérieur ;
- la figure 2 montre la composition des différents champs en présence ;
- la figure 3 illustre une courbe de dispersion autour de la résonance ;
- la figure 4 montre une autre variante de magnétomètre selon l'art antérieur, à champ d'agitation ;
- la figure 5 illustre la courbe de dispersion obtenue avec un magnétomètre de ce dernier type ;
- la figure 6 montre encore une autre variante de magnétomètre selon l'art antérieur à champ d'agitation et à champ de contre-réaction ;
- la figure 7 est un schéma général d'un magnétomètre conforme à l'invention ;
- la figure 8 illustre un premier mode de réalisation d'un magnétomètre à additionneur de courant,
- la figure 9 est un schéma explicatif du dispositif de la figure précédente ;
- la figure 10 illustre un deuxième mode de réalisation d'un magnétomètre à enroulement spécifique de contre-réaction ;
- la figure 11 illustre un autre mode de réalisation à étalonnage numérique ;
- la figure 12 illustre un algorithme de formation d'un nombre par pas successifs ;
- la figure 13 illutre un algorithme de formation d'un nombre par approximations successives ;
- la figure 14 illustre un algorithme à deux nombres successifs, respectivement positif et négatif ;
- la figure 15 illustre un mode de réalisation à deux nombres et à deux convertisseurs numérique-analogique et à additionneur de courant ;
- la figure 16 illustre encore un mode de réalisation à deux nombres et à deux convertisseurs numérique-analogique mais à deux enroulements spécifiques ;
- la figure 17 illustre un algorithme de fonctionnement à deux nombres ;
- la figure 18 montre un exemple de circuit logique utilisable dans l'invention ;
- la figure 19 est un diagramme explicatif du fonctionnement du circuit logique de la figure précédente.

## Exposé détaillé de modes de réalisation

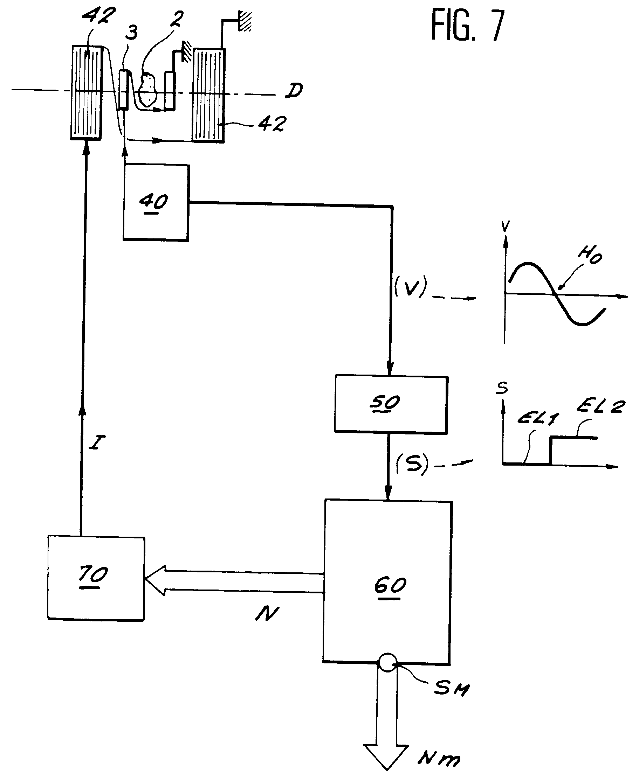

La figure 7 est un schéma général d'un magnétomètre conforme à l'invention. Les moyens déjà utilisés dans l'art antérieur sont symbolisés par un bloc référencé 40. Il faut comprendre qu'il s'agit des moyens déjà décrits à propos des figures 1, 4 et 6, pris seuls ou en combinaison, et qui permettent d'exciter la résonance, de la détecter et de fournir un signal V s'annulant lorsque le champ magnétique total prend la valeur Ho correspondant à la résonance.

Le magnétomètre de l'invention est caractérisé par un circuit logique 50, qui reçoit le signal en question et délivre un signal logique S pouvant prendre deux états logiques EL1, EL2, le second indiquant que le signal V s'est annulé, c'est-à-dire qu'on est passé à la résonance.

Le magnétomètre de l'invention comprend encore un processeur (ou contrôleur) 60, qui reçoit le signal logique S et délivre un signal numérique N, autrement dit un nombre à plusieurs bits (par exemple 8 ou 16 bits ou plus).

Ce processeur 60 délivre par ailleurs, sur une sortie de mesure notée SM, un nombre qui a la valeur mémorisée prise finalement par le nombre N lorsque la résonance a eu lieu.

Le magnétomètre de l'invention comprend encore un convertisseur numérique-analogique 70, qui reçoit le nombre N et le transforme en courant I (soit directement, soit par l'intermédiaire d'une tension, elle-même convertie ensuite en courant). Le courant I alimente un enroulement 42 disposé à proximité de l'échantillon 2. Il faut comprendre que cet enroulement 42 peut être soit un enroulement spécifique, ajouté aux autres enroulements existant classiquement dans un magnétomètre (tels qu'ils ont été représentés sur la figure 6 sous les références 3 et 24), soit l'un quelconque de ces enroulements puisqu'il s'agit de créer un champ de contre-réaction devant être dirigé selon la direction générale D commune à tous ces enroulements.

Le fonctionnement général de l'appareil de la figure 7 est alors le suivant.

Lorsque le champ magnétique à mesurer est nul, le courant de polarisation est réglé pour qu'on soit à la résonance. Alors, la tension V est nulle et le signal logique S délivré par le circuit 50 est dans son second état logique EL2. Le processeur 60 délivre un nombre N nul. Aucun courant de contre-réaction I n'est appliqué à l'enroulement 42.

Lorsqu'un champ Hm est appliqué à l'échantillon, la résonance ne se produit plus, la tension V n'est plus nulle mais prend une valeur qui constitue un signal d'erreur. Le signal logique S passe dans son premier état logique EL1. Le processeur 60 incrémente alors le nombre N (en positif ou en négatif) par un algorithme approprié, de telle sorte qu'un courant soit appliqué à l'enroulement 42. Il en résulte un champ de contre-réaction qui modifie le champ total appliqué à l'échantillon 2 jusqu'à ce que la projection de Hm sur la direction D soit exactement compensée par le champ de contre-réaction. Alors, la tension V repasse par zéro, le signal logique S reprend son second état logique EL2 indiquant au processeur 60 que la résonance a été rétablie. Le processeur bloque alors le nombre N à la valeur prise Nm et délivre cette valeur Nm sur la sortie de mesure SM. Cette valeur Nm est la valeur en numérique de la projection du champ Hm à mesurer sur la direction D.

Si l'on désigne par bo la valeur du champ magnétique obtenue pour un nombre N égal à 1 (c'est-à-dire lorsque le bit le moins significatif de N est à 1, les autres bits étant tous à 0), le champ mesuré correspondant à la valeur finale Nm est égal à Nmbo+ , où est un terme d'erreur inférieur à bo.

Dans le schéma de la figure 7, les moyens d'assurer la résonance par réglage du champ de polarisation ne sont pas représentés explicitement et sont supposés contenus dans le moyen général 40 qui contient donc la source de courant permettant de créer ce champ de polarisation via l'enroulement 3.

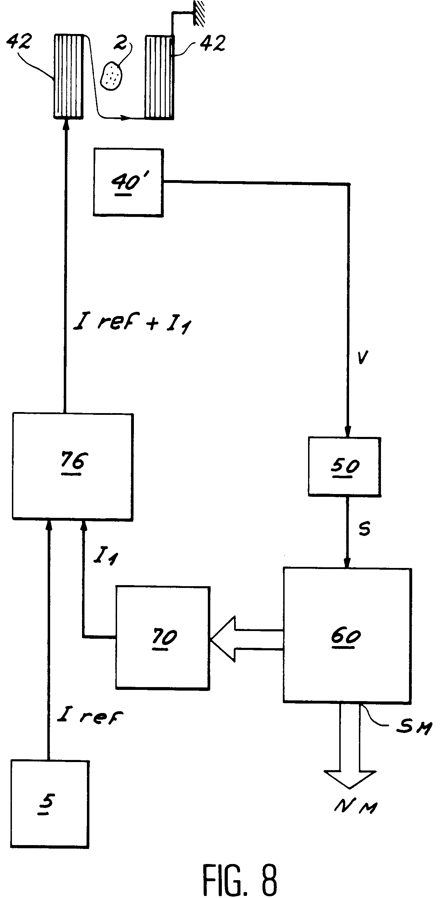

Dans le schéma de la figure 8, au contraire, la source de courant de référence 5 qui permet de créer ce champ via l'enroulement 42 est explicitement représentée (le moyen général dépourvu de cette source est alors référencé 40'). Le courant de référence Iref est réglé à une valeur Io. On ajoute à ce courant le courant I1 délivré par le convertisseur 70 et ceci dans un additionneur 76 qui délivre la somme Io+I1, laquelle est appliquée à l'enroulement 42.

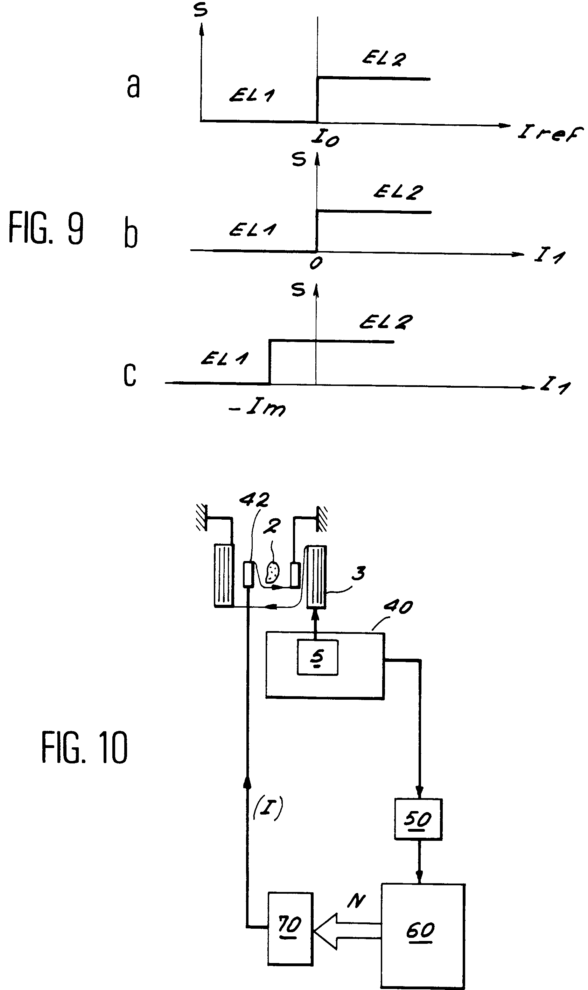

La figure 9 montre les variations de quelques signaux apparaissant dans les dispositifs des figures 7 et 8.

Sur la partie (a) tout d'abord, le courant de référence Iref délivré par la source 5 est porté en abscisses et le signal logique S est en ordonnées. Si, en l'absence de champ à mesurer, le courant Iref est inférieur à la valeur Io correspondant à la résonance, le signal S est dans son premier état logique EL1. Si le courant Iref franchit la valeur Io, le signal S bascule et prend son second état logique EL2.

Toujours en l'absence de champ à mesurer, le courant I1 (partie b) délivré par le convertisseur 70, est nul.

En cas de champ à mesurer, il faut un courant I1 égal à -Im pour obtenir à nouveau la résonance, c'est-à-dire pour faire basculer le signal logique S de l'état EL1 à l'état EL2 (partie c).

Le mode de réalisation de la figure 8 est simple mais il est tributaire de la stabilité de la source 5. La précision de la mesure dépend de la valeur de bo et de la capacité du convertisseur 70, laquelle doit correspondre à la valeur maximum du champ Hm. Une erreur peut s'introduire lors de la variation de bo.

Dans la variante de réalisation illustrée sur la figure 10, les moyens de formation du champ de polarisation et ceux du champ de contre-réaction sont séparés : les premiers sont constitués par la source 5 située dans le moyen général 40 et l'enroulement référencé 3, tandis que les seconds sont constitués par le convertisseur 70 et l'enroulement spécifique 42.

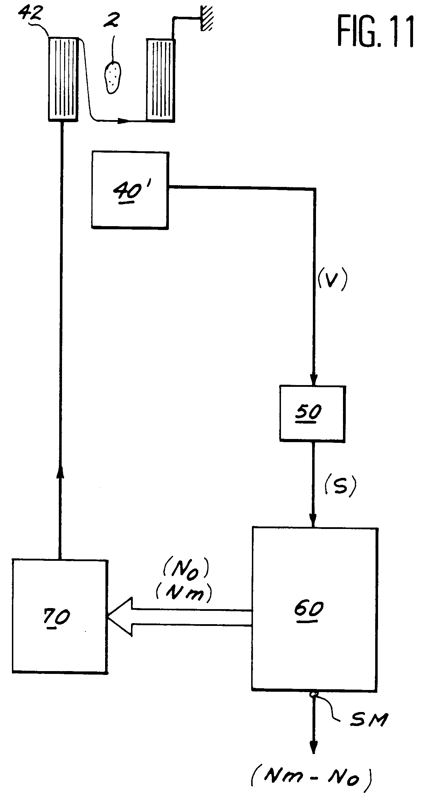

Dans la variante de la figure 11, les moyens numériques remplissent non seulement la fonction de mesure mais encore celle d'étalonnage préalable. Pour cela, lorsque le champ à mesurer Hm est absent, le processeur délivre un nombre N de valeur No correspondant à la résonance. Le champ appliqué est alors Nobo+ $\varepsilon$ (où $\varepsilon$ est encore un terme d'erreur majoré par bo). En présence d'un champ à mesurer Hm, le processeur rétablit la résonance en formant un nombre Nm différent de No et apte à créer un champ de contre-réaction de valeur (Nm-No)bo qui s'opposera à la composante du champ à mesurer selon la direction D. La valeur numérique du champ sera donnée par (Nm-No). C'est elle qui apparaît sur la sortie de mesure SM du processeur 60. L'erreur commise est alors inférieure à 2bo.

Ce mode de réalisation présente l'inconvénient de nécessiter un nombre No beaucoup plus grand que Nm (car le champ de polarisation est, dans ce genre d'appareil et comme déjà souligné, très supérieur au champ à mesurer). Il faut donc utiliser un convertisseur 70 à grande dynamique. Pour une valeur du champ à mesurer de 100 $\mu$T et une valeur de champ de polarisation de 1 mT, on obtient, comme excursion maximale du convertisseur, 1,1 mT, ce qui donne une résolution minimale, pour un convertisseur de 16 bits :

$$bo = 1,1/2^{16} = 17 \text{ nT (environ)}$$

ou encore, pour un convertisseur de 20 bits, environ 1 nT.

Cette résolution est malheureusement supérieure à la résolution que l'on peut attendre d'un magnétomètre directionnel à résonance. On utilisera donc avantageusement des variantes à plusieurs convertisseurs comme il sera décrit plus bas.

Un deuxième inconvénient du mode de réalisation de la figure 11 est lié à l'étalonnage préalable effectué de manière numérique. Si bo varie, la mesure peut se trouver erronée. Ce problème peut être résolu en effectuant deux mesures successives, l'une avec un champ de polarisation dirigé dans un sens, l'autre avec un champ dirigé dans l'autre sens. On obtient alors, en sortie du processeur, successivement deux nombres, noté $N^+m$ et $N^-m$ avec les relations suivantes :

$$N^+m \; bo \; + \; \varepsilon^+ \; = \; Ho \; + \; Hm$$
$$N^-m \; bo \; + \; \varepsilon^- \; = \; Ho \; - \; Hm$$

ce qui donne la valeur du champ à mesurer Hm indépendamment de bo :

$$Hm \; = \; (N^-m - N^+m)/(N^+m + N^-m) \; Ho \; + \; \varepsilon'$$

où $\varepsilon'$ est un terme d'erreur inférieur à 2bo.

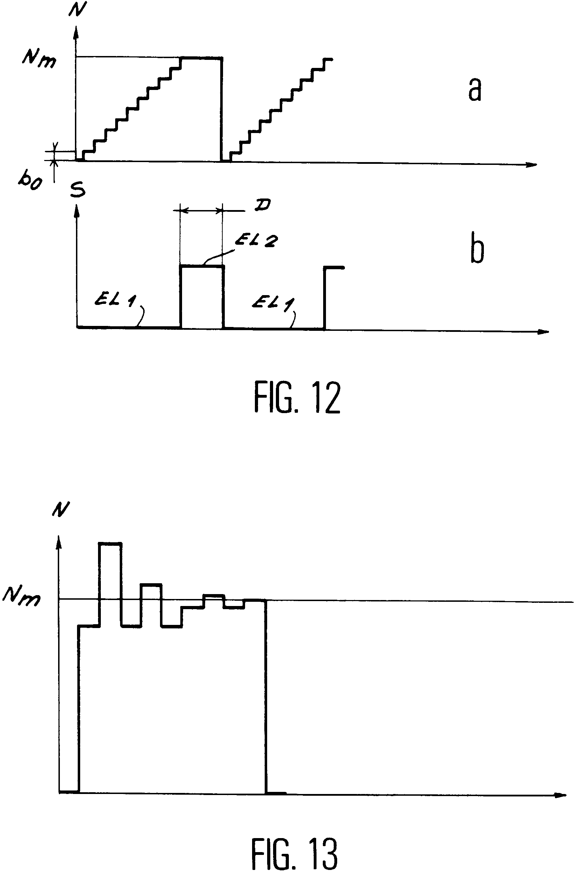

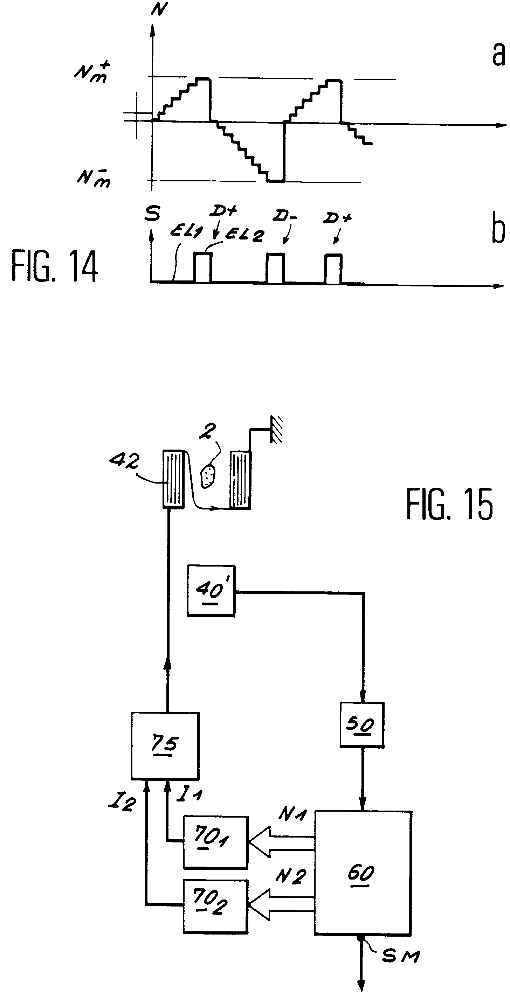

Tout algorithme convient pour incrémenter ou décrémenter le nombre N jusqu'à l'apparition de la résonance. A titre d'exemples non limitatifs, les figures 12 et 13 illustrent des algorithmes respectivement à pas successifs et à approximations successives et la figure 14 un algorithme à pas successifs et à deux nombres.

Sur la figure 12, tout d'abord, on voit, sur la partie (a), le champ H incrémenté pas à pas avec une amplitude bo, qui correspond au bit le moins significatif du nombre N. Ce nombre N croît ainsi d'une unité à chaque échantillonnage, lequel est défini par une horloge contenue dans le processeur. Pendant cette incrémentation, le signal logique S délivré par le circuit logique 50 et montré sur la partie (b) de la figure 12, demeure dans son premier état logique EL1, en l'occurrence l'état bas.

Cependant, lorsque le champ total atteint la valeur Ho correspondant à la résonance, le signal S bascule sur son deuxième état logique EL2, en l'occurrence l'état haut, et le processeur bloque l'incrémentation du nombre N. L'arrêt se maintient pendant une durée D pour permettre la mémorisation du nombre obtenu.

Le nombre N est ensuite remis à zéro, ce qui fait rebasculer le circuit logique 50 sur l'état EL1 et l'incrémentation reprend.

Sur la figure 13 est schématisé un algorithme par approximations successives, qui permet d'obtenir plus rapidement la valeur recherchée. Au lieu d'agir en premier lieu sur le bit le moins significatif de N, comme dans la variante de la figure 12, on agit sur le bit le plus significatif et on teste le signal S. Si celui-ci est passé à son second niveau logique EL2, indiquant que la résonance a été franchie, le bit le plus significatif est remis à zéro, sinon il est laissé à 1 et le bit suivant de poids plus faible est commuté de 0 à 1. A nouveau, si le signal S indique que la résonance a été dépassée, le second bit est remis à 0 sinon il est laissé à 1. La procédure se poursuit ainsi jusqu'au bit de plus faible poids. Dans le cas illustré sur la figure 13, le bit le plus significatif n'a pas permis, à lui seul, d'atteindre la résonance mais le bit suivant a permis de la dépasser. Il a donc été ramené à 0. De même pour le troisième bit (dans l'ordre des poids décroissants). Le quatrième bit, en revanche, a été maintenu à 1 ; mais le cinquième a été remis à 0 etc.

Comme dans le cas de la figure 12, lorsque la valeur correspondant à la résonance est atteinte, la valeur de N obtenue est mémorisée et affichée sur la sortie du processeur. Le nombre N est ensuite remis à 0.

Lorsqu'on travaille avec deux nombres successifs de signes opposés, comme expliqué plus haut, afin d'éliminer l'étalonnage préalable sur bo, on peut utiliser les algorithmes précédents, (figs. 12 et 13) ou tout autre. A titre d'exemple, la figure 14 montre comment on recherche les deux nombres $N^+m$ et $N^-m$ par approximations successives, d'abord pour le nombre positif $N^+$, ensuite pour le nombre négatif $N^-$ (partie (a)). La partie (b) de la figure montre l'allure du signal logique S et les périodes $D^+$ et $D^-$ de mémorisation des nombres positif et négatif obtenus.

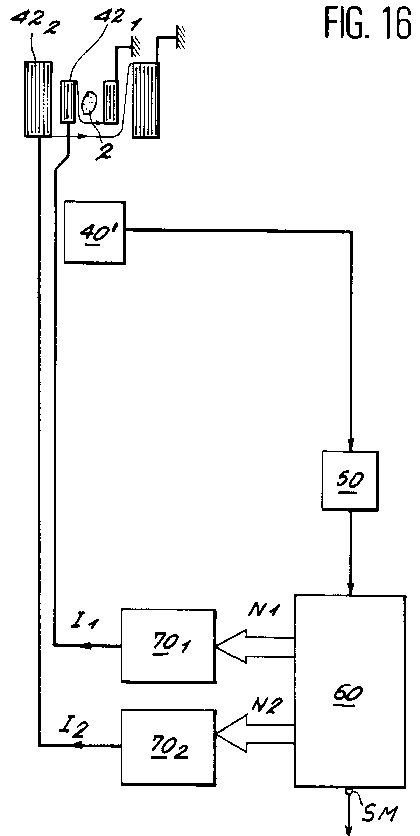

Dans les variantes qui viennent d'être décrites un seul convertisseur numérique-analogique est utilisé. Dans une variante plus complexe, on peut utiliser deux convertisseurs de poids différents. C'est ce qui est représenté sur les figures 15 et 16 où les deux convertisseurs portent les références $70_1$ et $70_2$. Ils délivrent respectivement des courants $I_1$ et $I_2$. La différence entre les deux modes de réalisation illustrés tient à ce que, dans le premier cas (fig.15), les deux courants $I_1$ et $I_2$ sont ajoutés l'un à l'autre dans un additionneur 75, la somme résultante étant appliquée à un seul enroulement 42 alors que, dans le second cas (fig. 16), chaque courant $I_1$, $I_2$ alimente un enroulement spécifique respectivement $42_1$, $42_2$.

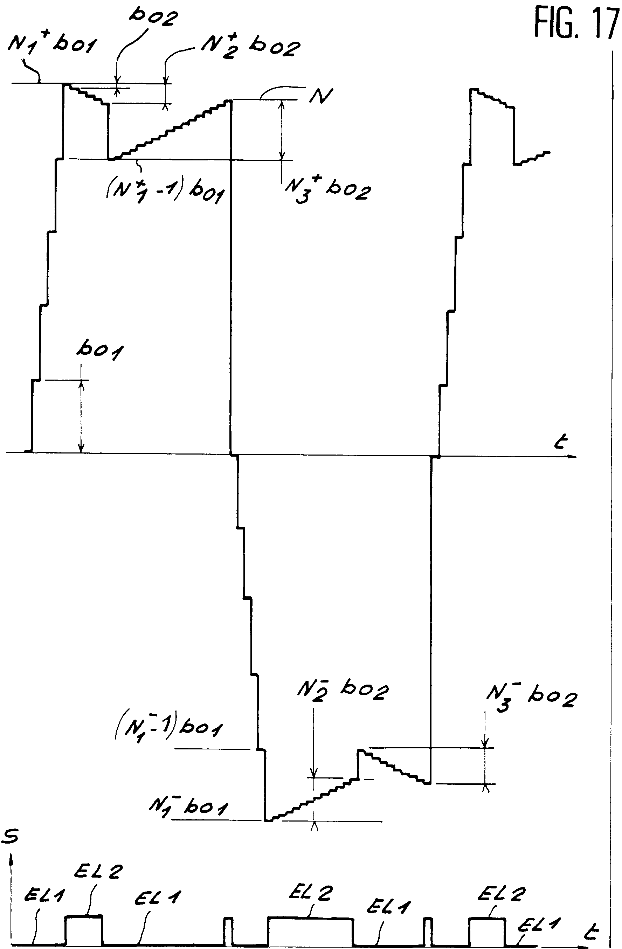

Un algorithme particulier valable pour les variantes à deux convertisseurs de poids différents est illustré sur la figure 17. Le deuxième convertisseur $70_2$ est supposé posséder une unité bo2 telle que bo2 soit supérieure à bo1/Nm2. Cette variante permet une mesure absolue du champ avec une résolution égale à (Ho+Hmmax)/2(Nmax1+Nmax2), où Hmmax est l'amplitude maximale du champ à mesurer et Nmax1 et Nmax2 sont les valeurs maximales des nombres N1 et N2 appliqués aux deux convertisseurs. La séquence des opérations est la suivante :

1) incrémentation du convertisseur $70_1$ de plus grand poids dans le sens positif jusqu'au delà de la résonance ; mesure de $N_1^+$ et maintient de cette valeur ;

2) incrémentation du convertisseur de plus faible poids $70_2$ dans le sens négatif (autrement dit décrémentation) jusqu'au delà de la résonance ; mesure de $N_2^+$ ;

3) positionnement du premier convertisseur $70_1$ à $N_1^+$-1 ;

4) incrémentation du convertisseur de plus faible poids $70_2$ dans le sens positif jusqu'au delà de la résonance ; mesure de $N_2^+$.

On tire des nombres ainsi obtenus les relations :

$$(1) \qquad Ho + Hm = N_1 + bo1 - N_2 + bo2 = (N_1^+ - 1)bo1 + N_3 + bo2$$

$$(2) \qquad (N_3^+ + N_2^+ - 1)bo2 = bo1$$

La relation (2) permet de relier bo1 à bo2. Les termes d'erreur n'ont pas été écrits, mais sont majorés par bo2.

Une séquence analogue dans le sens négatif permet d'obtenir :

$$(3) \qquad Ho - Hm = N_1^- bo1 - N_2^- bo2 = (N_1^- - 1)bo1 + N_3^- bo2$$

$$(4) \qquad (N_3^- + N_2^- - 1)bo2 = bo1$$

Ce qui permet de calculer Hm :

$$Hm = \frac{(N_1^+ - N_1^-)(N_3^+ + N_2^+ + N_3^- + N_2^- - 2) - 2(N_2^+ - N_2^-)}{(N_1^+ + N_1^-)(N_3^+ + N_2^+ + N_{+3}^- + N_2^- - 2) - 2(N_2^+ + N_2^-)} Ho$$

en utilisant une moyenne de (2) et (4) pour minimiser l'erreur sur la relation entre bo1 et bo2.

D'autres algorithmes ou d'autres variantes de réalisation peuvent être utilisées. Elles peuvent être déduites d'algorithmes de conversion numérique-analogique connus.

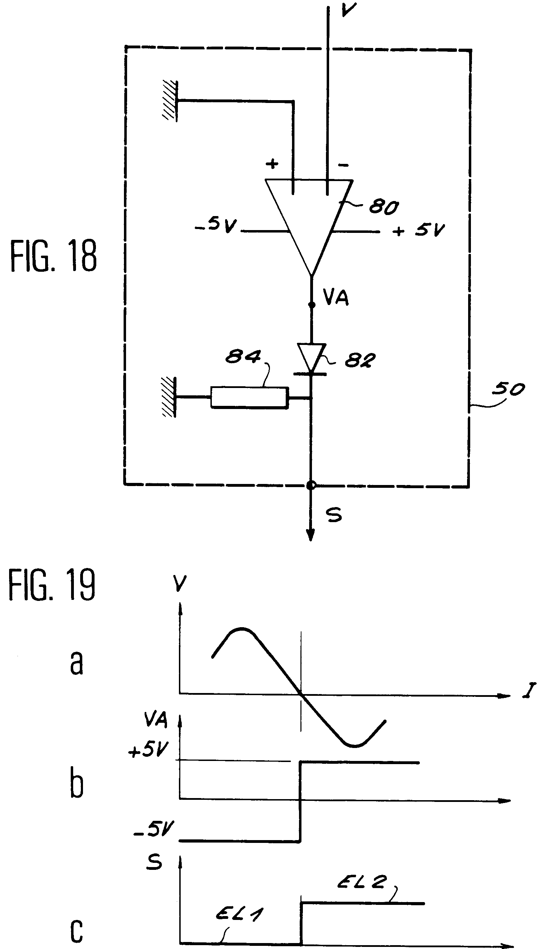

Quant au circuit logique 50 destiné à produire le signal logique S, l'homme du métier pourra aisément en concevoir la structure. A titre d'exemple, la figure 18 montre un mode de réalisation possible de ce circuit. Il s'agit d'un circuit comprenant un comparateur-inverseur 80 alimenté en ± 5 volts et tel que sa tension de sortie soit égale à -5 V lorsque sa tension d'entrée est faiblement positive et égale à+ 5 V lorsque sa tension d'entrée est faiblement négative. Ce comparateur est suivi d'une diode 82 chargée par une résistance 84, l'ensemble permettant de ne retenir que la valeur positive de la tension de sortie du comparateur.

Les tensions apparaissant en différents points du circuit sont représentées sur la figure 19 : en (a) est représentée la tension d'entrée V (qui est la tension antisymétrique fournie par les moyens 40) (cf. figures 3 et 5), en (b) la tension VA au point A à la sortie du comparateur-inverseur 80, et en (c) le signal logique S délivré finalement par le circuit 50.

## Revendications

1. Magnétomètre directionnel à résonance de type numérique comprenant :
   - un échantillon à spins (2) plongeant dans un champ magnétique à mesurer (Hm),
   - des premiers moyens (4, 6, 8) d'excitation de la résonance des spins dans l'échantillon (2),
   - des deuxièmes moyens (4, 8) de détection de cette résonance,
   - des troisièmes moyens (16, 18, 20, 26, 28) pour délivrer un signal (V1, Vs) qui est nul lorsque le champ appliqué à l'échantillon (2) a une valeur (Ho) correspondant à la résonance et qui est positif ou négatif lorsque le champ appliqué (H) s'écarte de cette valeur (Ho),
   - des quatrièmes moyens de contre-réaction aptes à créer un champ de contre-réaction rétablissant la valeur (Ho) du champ (H) correspondant à la résonance,
   ce magnétomètre étant caractérisé par le fait que les quatrièmes moyens de contre-réaction sont au moins en partie numérique et comprennent :
   - un organe logique (50) recevant ledit signal (V1, Vs) délivré par lesdits troisièmes moyens, cet organe logique délivrant un signal logique (S) qui passe d'un premier état logique (EL1) à un second état logique (EL2) lorsque ledit signal (V1, Vs) passe par zéro,
   - un processeur numérique (60) ayant une entrée reliée audit organe logique (50) et une sortie délivrant au moins un nombre binaire N, le processeur (60) bloquant le nombre qu'il délivre lorsque le signal logique (S) qu'il reçoit de l'organe logique (50) prend son second état logique (EL2),
   - au moins un convertisseur numérique-analogique (70, $70_1$, $70_2$), recevant ledit nombre (N) délivré par le processeur numérique (60), et délivrant un signal électrique (I1) proportionnel à ce nombre, ce signal servant à constituer le champ de contre-réaction, le processeur (60) possédant une sortie de mesure (SM) délivrant la valeur (Nm) du nombre N correspondant à la résonance, cette valeur (Nm) constituant la mesure en numérique du champ (Hm) appliqué à l'échantillon (2).

2. Magnétomètre selon la revendication 1, caractérisé par le fait que les moyens pour former le champ de contre-réaction comprennent en outre :
   - le convertisseur numérique-analogique (70) recevant le nombre (N) délivré par le processeur (60) et délivrant un premier courant (I1) proportionnel à ce nombre,

- une source de courant de référence (5) correspondant à la résonance en l'absence de champ à mesurer, et délivrant un second courant (Iref).

3. Magnétomètre selon la revendication 2, caractérisé par le fait que lesdits moyens pour former le champ de contre-réaction comprennent en outre un additionneur de courant (76) recevant le premier et le second courants (Io, Iref), cet additionneur étant relié à un enroulement (3, 42).

4. Magnétomètre selon la revendication 2, caractérisé par le fait que le convertisseur (70) numérique-analogique est un convertisseur numérique-analogique en courant.

5. Magnétomètre selon la revendication 2, caractérisé par le fait que le convertisseur (70) numérique-analogique est un convertisseur numérique-analogique en tension suivi d'un convertisseur tension-courant.

6. Magnétomètre selon la revendication 2, caractérisé par le fait que le convertisseur numérique-analogique (70) est relié à un enroulement spécifique et la source de courant (5) à un autre enroulement (3) de même axe.

7. Magnétomètre selon la revendication 1, caractérisé par le fait que le processeur (60) délivre deux nombres (N1) et (N2) de poids différents et par le fait que les moyens pour former le champ de contre-réaction comprennent :
   - un premier convertisseur numérique-analogique ($(70)_1$) recevant le premier nombre (N1) et délivrant un premier courant (I1),
   - un second convertisseur numérique-analogique ($(70)_2$) recevant le second nombre (N2) et délivrant un second courant (I2).

8. Magnétomètre selon la revendication 7, caractérisé par le fait qu'il comprend un additionneur (75) recevant les premier et second courants (I1, I2) et alimentant un enroulement unique,

9. Magnétomètre selon la revendication 7, caractérisé par le fait que le premier convertisseur numérique-analogique ($(70)_1$) est relié à un premier enroulement et le second convertisseur numérique-analogique ($(70_2$) à un second enroulement ($44_2$).

10. Magnétomètre selon la revendication 1, caractérisé par le fait que le processeur (60) est apte à incrémenter le nombre (N) par pas successifs.

11. Magnétomètre selon la revendication 1, caractérisé par le fait que le processeur (60) est apte à faire varier le nombre (N) par approximations successives.

12. Magnétomètre selon la revendication 1, caractérisé en ce qu'il comporte en outre des moyens d'agitation (21, 24) aptes à créer un champ d'agitation.

13. Magnétomètre selon la revendication 1, caractérisé en ce que les moyens de contre-réaction sont aptes en outre à créer un champ de polarisation.

14. Magnétomètre selon la revendication 7, caractérisé par le fait qu'il comprend les moyens pour :
    A) effectuer une première séquence d'opérations dans un sens positif, cette séquence comprenant les opérations suivantes :
       - incrémenter le premier convertisseur ($70_1$) de plus grand poids dans le sens positif jusqu'au delà de la résonance ;
       - mesurer le nombre ($N_1$) et maintenir cette valeur ($N_1^+$) ;
       - incrémenter le convertisseur de plus faible poids ($70_2$) dans le sens négatif jusqu'au delà de la résonance ;
       - mesurer le nombre ($N_2$) et maintenir cette valeur ($N_2^+$) ;
       - positionner le premier convertisseur ($70_1$) à $N_1^+$-1 ;
       - mesurer la valeur de ($N_2$) ($N_2^+$),
    B) réitérer cette séquence d'opérations mais dans le sens négatif et obtenir des valeurs ($N_1^-$, $N_2^-$),
    C) calculer le champ (Hm) à partir des valeurs ($N_1^+$, $N_2^+$, $N_1^-$, $N_2^-$).

EP 0 616 227 A1

# FIG. 1

# FIG. 2

# FIG. 3

FIG. 4

FIG. 5

FIG. 6

FIG. 7

FIG. 8

FIG. 9

a

b

c

FIG. 10

FIG. 11

FIG. 12

FIG. 13

FIG. 14

FIG. 15

FIG. 16

FIG. 17

FIG. 18

V

+ −

80

−5V _____ + 5V

VA

84 82

50

S

FIG. 19

V

a

I

VA

+5V

b

−5V

S

c

EL1

EL2

**Office européen des brevets**

# RAPPORT DE RECHERCHE EUROPEENNE

Numero de la demande

EP 94 40 0546

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | EP-A-0 240 221 (KABUSHIKI KAISHA TOSHIBA) * abrégé * * colonne 6, ligne 28 - colonne 10, ligne 11; figures 1,3,4,6,10,11 * | 1,10 | G01R33/24 |
| A,D | EP-A-0 463 919 (COMMISSARIAT A L'ENERGIE ATOMIQUE) * abrégé * * colonne 6, ligne 3 - colonne 8, ligne 34; figures 7,10-13 * | 1,13 | |
| A | EP-A-0 522 191 (SPECTROSPIN AG) * page 3, ligne 24 - page 4, ligne 13; figure 1 * | 1 | |
| A | INSTRUMENTS AND EXPERIMENTAL TECHNIQUES., vol.22, no.2, 1 Mars 1979, NEW YORK US pages 504 - 508 E.V. DVORNIKOV 'LARGE-SCALE AUTOMATION OF A NUCLEAR MAGNETIC RESONANCE MAGNETOMETER' * le document en entier * | 1,10 | |
| A | JOURNAL OF PHYSICS E. SCIENTIFIC INSTRUMENTS, vol.12, no.7, 1 Juillet 1979, BRISTOL GB pages 640 - 643 J. KUBIAK ET AL. 'A NEW FIELD-TRACKING NMR MAGNETOMETER SYSTEM' * le document en entier * | 1 | **DOMAINES TECHNIQUES RECHERCHES (Int.Cl.5)** G01R |
| A | INSTRUMENTS AND EXPERIMENTAL TECHNIQUES., vol.24, no.6, 1 Novembre 1981, NEW YORK US pages 1467 - 1472 A.E. PRYAKHIN 'TRACKING NUCLEAR MAGNETIC RESONANCE MAGNETOMETER WITH DIGITAL READOUT IN GAUSS' * le document en entier * | 1 | |

Le présent rapport a été établi pour toutes les revendications

| Lieu de la recherche | Date d'achèvement de la recherche | Examinateur |
|---|---|---|
| LA HAYE | 1 Juin 1994 | Horak, G |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)